(19) Europäisches Patentamt
European Patent Office
Office européen des brevets

(11) **EP 4 177 931 A2**

(12) **EUROPEAN PATENT APPLICATION**

(43) Date of publication:
**10.05.2023 Bulletin 2023/19**

(21) Application number: **22198342.2**

(22) Date of filing: **28.09.2022**

(51) International Patent Classification (IPC):
**H01L 21/02** (2006.01)    **C23C 16/32** (2006.01)
**C30B 23/00** (2006.01)

(52) Cooperative Patent Classification (CPC):
**H01L 21/02378; C23C 16/325; C30B 23/005;
H01L 21/02447; H01L 21/02502; H01L 21/02529;
H01L 21/0257; H01L 21/0262**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **08.11.2021 JP 2021182164**

(71) Applicant: **NuFlare Technology, Inc.
Yokohama-shi, Kanagawa 235-8522 (JP)**

(72) Inventors:
• **Daigo, Yoshiaki**
  **Yokohama-shi, Kanagawa 235-8522 (JP)**
• **Moriyama, Yoshikazu**
  **Yokohama-shi, Kanagawa 235-8522 (JP)**
• **Watanabe, Toru**
  **Yokohama-shi, Kanagawa 235-8522 (JP)**
• **Iwasaki, Masataka**
  **Yokohama-shi, Kanagawa 235-8522 (JP)**

(74) Representative: **Hoffmann Eitle
Patent- und Rechtsanwälte PartmbB
Arabellastraße 30
81925 München (DE)**

(54) **VAPOR PHASE GROWTH METHOD AND VAPOR PHASE GROWTH APPARATUS**

(57)    A vapor phase growth method of embodiments includes: forming a first silicon carbide layer having a first doping concentration on a silicon carbide substrate at a first growth rate by supplying a first process gas under a first gas condition; forming a second silicon carbide layer having a second doping concentration at a second growth rate higher than the first growth rate by supplying a second process gas under a second gas condition; and forming a third silicon carbide layer having a third doping concentration lower than the first doping concentration and the second doping concentration at a third growth rate higher than the second growth rate by supplying a third process gas under a third gas condition.

FIG.4A

ELAPSED TIME AFTER START OF EPITAXIAL GROWTH

EP 4 177 931 A2

**Description**

CROSS-REFERENCE TO RELATED APPLICATION

This application is based upon and claims the benefit of priority from Japanese Patent Applications No. 2021-182164, filed on November 8, 2021, the entire contents of which are incorporated herein by reference.

FIELD OF THE INVENTION

Embodiments relate to a vapor phase growth method and a vapor phase growth apparatus for supplying a gas to form a film.

BACKGROUND OF THE INVENTION

As a method of forming a high-quality semiconductor film, there is an epitaxial growth technique in which a single crystal film is grown on a substrate, such as a wafer, by vapor phase growth. In a vapor phase growth apparatus using the epitaxial growth technique, a wafer is placed on a substrate holding portion in a reactor maintained at atmospheric pressure or lower pressure.

Then, while heating the wafer, a process gas such as a source gas, which is a raw material for the semiconductor film, is supplied from the upper part of the reactor to the wafer surface in the reactor, for example. Pyrolysis and chemical reaction of the source gas occur on the wafer surface, and an epitaxial single crystal film is formed on the wafer surface.

When forming a silicon carbide layer on the substrate by using the epitaxial growth technique, a crystal defect is generated in the silicon carbide layer. If a crystal defect is present in the silicon carbide layer, for example, the reliability of the semiconductor device formed on the silicon carbide layer is reduced, which causes a problem. Therefore, it is desired to reduce the crystal defect density in the silicon carbide layer.

SUMMARY OF THE INVENTION

A vapor phase growth method of embodiments includes: forming a first silicon carbide layer having a first doping concentration on a silicon carbide substrate at a first growth rate by supplying a first process gas containing a carrier gas into a reactor under a first gas condition; forming a second silicon carbide layer having a second doping concentration at a second growth rate higher than the first growth rate by supplying a second process gas containing a carrier gas into the reactor under a second gas condition after the forming the first silicon carbide layer; and forming a third silicon carbide layer having a third doping concentration lower than the first doping concentration and the second doping concentration at a third growth rate higher than the second growth rate by supplying a third process gas containing a carrier gas into the reactor under a third gas condition after the forming the second silicon carbide layer.

A vapor phase growth apparatus of embodiments includes: a reactor; a carrier gas supply pipe supplying a carrier gas to the reactor; a first source gas supply pipe supplying a first source gas containing silicon (Si) to the reactor; a second source gas supply pipe supplying a second source gas containing carbon (C) to the reactor; a first mass flow controller provided in the carrier gas supply pipe to control a flow rate of the carrier gas supplied to the reactor; a second mass flow controller provided in the first source gas supply pipe to control a flow rate of the first source gas supplied to the reactor; a third mass flow controller provided in the second source gas supply pipe to control a flow rate of the second source gas supplied to the reactor; a pressure adjusting valve adjusting a pressure in the reactor; and a control circuit controlling the first mass flow controller, the second mass flow controller, the third mass flow controller, and the pressure adjusting valve so that an average residence time of the carrier gas in the reactor is shorter than a transition time when switching the flow rate of at least one of the first source gas and the second source gas supplied to the reactor at the transition time.

BRIEF DESCRIPTION OF THE DRAWINGS

Fig. 1 is a schematic diagram of a vapor phase growth apparatus of embodiments;
Fig. 2 is a schematic cross-sectional view of an example of a silicon carbide layer formed by a vapor phase growth method of embodiments;
Fig. 3 is an explanatory diagram of the vapor phase growth method of embodiments;
Figs. 4A and 4B are explanatory diagrams of the vapor phase growth method of embodiments;
Fig. 5 is a schematic cross-sectional view of a silicon carbide layer formed by a vapor phase growth method of a first comparative example;

Fig. 6 is a schematic cross-sectional view of a silicon carbide layer formed by a vapor phase growth method of a second comparative example;

Fig. 7 is an explanatory diagram of the function and effect of the vapor phase growth method of embodiments;

Fig. 8 is a schematic diagram of a first modification example of the vapor phase growth apparatus of embodiments; and

Fig. 9 is a schematic diagram of a second modification example of the vapor phase growth apparatus of embodiments.

## DETAILED DESCRIPTION OF THE EMBODIMENTS

Hereinafter, embodiments will be described with reference to the diagrams.

In this specification, the same or similar members may be denoted by the same reference numerals.

In this specification, the direction of gravity in a state in which a vapor phase growth apparatus is installed so that a film can be formed is defined as "down", and the opposite direction is defined as "up". Therefore, "lower" means a position in the direction of gravity with respect to the reference, and "downward" means the direction of gravity with respect to the reference. Then, "upper" means a position in a direction opposite to the direction of gravity with respect to the reference, and "upward" means a direction opposite to the direction of gravity with respect to the reference. In addition, the "vertical direction" is the direction of gravity.

In addition, in this specification, "process gas" is a general term for gases used for forming a film on a substrate, and is a concept including, for example, a carrier gas, a source gas, a dopant gas, an assist gas, and a mixed gas thereof. The carrier gas forms a mainstream of gas after being introduced into the reactor, and gases such as a source gas, a dopant gas, and an assist gas may be used as gases to be transported onto a wafer in the reactor. In addition, the carrier gas may be mixed with a gas, such as a source gas, a dopant gas, or an assist gas, by connecting a gas supply pipe before being introduced into the reactor, thereby being also used as a gas to be transported to the reactor.

A vapor phase growth method of embodiments includes: forming a first silicon carbide layer having a first doping concentration on a silicon carbide substrate at a first growth rate by supplying a first process gas containing a carrier gas into a reactor under a first gas condition; forming a second silicon carbide layer having a second doping concentration at a second growth rate higher than the first growth rate by supplying a second process gas containing a carrier gas into the reactor under a second gas condition; and forming a third silicon carbide layer having a third doping concentration lower than the first doping concentration and the second doping concentration at a third growth rate higher than the second growth rate by supplying a third process gas containing a carrier gas into the reactor under a third gas condition.

In addition, a vapor phase growth apparatus of embodiments includes: a reactor; a carrier gas supply pipe for supplying a carrier gas to the reactor; a first source gas supply pipe for supplying a first source gas containing silicon (Si) to the reactor; a second source gas supply pipe for supplying a second source gas containing carbon (C) to the reactor; a first mass flow controller provided in the carrier gas supply pipe to control a flow rate of the carrier gas supplied to the reactor; a second mass flow controller provided in the first source gas supply pipe to control a flow rate of the first source gas supplied to the reactor; a third mass flow controller provided in the second source gas supply pipe to control a flow rate of the second source gas supplied to the reactor; a pressure adjusting valve for adjusting a pressure in the reactor; and a control unit for controlling the first mass flow controller, the second mass flow controller, the third mass flow controller, and the pressure adjusting valve so that an average residence time of the carrier gas in the reactor is shorter than a transition time when switching the flow rate of at least one of the first source gas and the second source gas supplied to the reactor at the transition time.

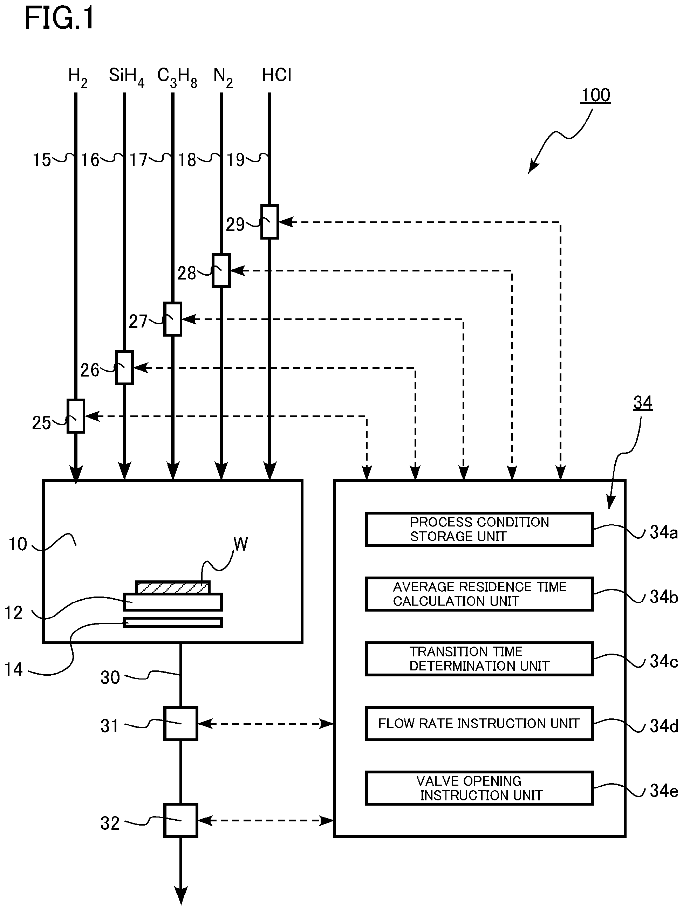

Fig. 1 is a schematic diagram of a vapor phase growth apparatus of embodiments. A vapor phase growth apparatus 100 of embodiments is, for example, an epitaxial growth apparatus for epitaxially growing a single crystal silicon carbide layer on a single crystal silicon carbide substrate.

The vapor phase growth apparatus 100 of embodiments includes a reactor 10, a susceptor 12, a heater 14, a carrier gas supply pipe 15, a first source gas supply pipe 16, a second source gas supply pipe 17, a dopant gas supply pipe 18, an assist gas supply pipe 19, a first mass flow controller 25, a second mass flow controller 26, a third mass flow controller 27, a fourth mass flow controller 28, a fifth mass flow controller 29, an exhaust pipe 30, a pressure adjusting valve 31, an exhaust pump 32, and a control unit 34. The control unit 34 includes a process condition storage unit 34a, an average residence time calculation unit 34b, a transition time determination unit 34c, a flow rate instruction unit 34d, and a valve opening instruction unit 34e.

The reactor 10 is formed of, for example, stainless steel. The reactor 10 has, for example, a cylindrical wall. A silicon carbide layer is formed on the surface of a wafer W in the reactor 10. The wafer W is an example of a substrate.

The susceptor 12 is provided inside the reactor 10. The susceptor 12 has a function of holding the wafer W. An opening may be provided at the center of the susceptor 12.

The heater 14 is provided inside the reactor 10. The heater 14 is provided below the susceptor 12. The heater 14 has a function of heating the wafer W. In addition, a heater (not shown) arranged in parallel to the side surface of the reactor 10 may be provided inside the reactor 10. A heater (not shown) arranged in parallel to the side surface of the reactor 10 can heat the wafer through a hot wall (not shown) arranged inside the heater.

The carrier gas supply pipe 15 is connected to the reactor 10. A plurality of carrier gas supply pipes 15 may be connected to the reactor 10. The carrier gas supply pipe 15 supplies a carrier gas to the reactor 10. The carrier gas is, for example, a hydrogen gas, an argon gas, or a helium gas. Only the carrier gas may be introduced into the reactor 10, or the carrier gas may be mixed with a gas, such as a source gas, a dopant gas, or an assist gas, to be introduced into the reactor 10.

The first source gas supply pipe 16 is connected to the reactor 10. The first source gas supply pipe 16 may be connected to the reactor 10 through the carrier gas supply pipe 15 by being connected to the carrier gas supply pipe 15. The first source gas supply pipe 16 supplies a first source gas containing silicon (Si) to the reactor 10. The first source gas is a raw material for forming a silicon carbide layer. The first source gas is, for example, a monosilane ($SiH_4$) gas.

The second source gas supply pipe 17 is connected to the reactor 10. The second source gas supply pipe 17 may be connected to the reactor 10 through the carrier gas supply pipe 15 by being connected to the carrier gas supply pipe 15. The second source gas supply pipe 17 supplies a second source gas containing carbon (C) to the reactor 10. The second source gas is a raw material for forming a silicon carbide layer. The second source gas is, for example, a propane ($C_3H_8$) gas.

The dopant gas supply pipe 18 is connected to the reactor 10. The dopant gas supply pipe 18 may be connected to the reactor 10 through the carrier gas supply pipe 15 by being connected to the carrier gas supply pipe 15. The dopant gas supply pipe 18 supplies a dopant gas to the reactor 10. The dopant gas contains an n-type impurity or a p-type impurity that serves as a dopant for the silicon carbide layer. The n-type impurity is, for example, nitrogen (N). The p-type impurity is, for example, aluminum (Al) or boron (B). The dopant gas of n-type impurities is, for example, a nitrogen gas. The dopant gas of p-type impurities is, for example, a trimethylaluminum (($CH_3)_3Al$) gas or a diborane ($B_2H_6$) gas.

The assist gas supply pipe 19 is connected to the reactor 10. The assist gas supply pipe 19 may be connected to the reactor 10 through the carrier gas supply pipe 15 by being connected to the carrier gas supply pipe 15. The assist gas supply pipe 19 supplies an assist gas to the reactor 10. The assist gas suppresses the clustering of silicon (Si), for example. The assist gas is, for example, a hydrogen chloride (HCl) gas.

The first mass flow controller 25 is provided in the carrier gas supply pipe 15. When a plurality of carrier gas supply pipes 15 are connected to the reactor 10, the first mass flow controller 25 may be provided in each carrier gas supply pipe 15. The first mass flow controller 25 has a function of monitoring the flow rate of the carrier gas supplied to the reactor 10 and controlling the flow rate of the carrier gas. The carrier gas is, for example, a hydrogen gas, an argon gas, or a helium gas.

The second mass flow controller 26 is provided in the first source gas supply pipe 16. The second mass flow controller 26 has a function of monitoring the flow rate of the first source gas supplied to the reactor 10 and controlling the flow rate of the first source gas. The first source gas is, for example, a monosilane gas.

The third mass flow controller 27 is provided in the second source gas supply pipe 17. The third mass flow controller 27 has a function of monitoring the flow rate of the second source gas supplied to the reactor 10 and controlling the flow rate of the second source gas. The second source gas is, for example, a propane gas.

The fourth mass flow controller 28 is provided in the dopant gas supply pipe 18. The fourth mass flow controller 28 has a function of monitoring the flow rate of the dopant gas supplied to the reactor 10 and controlling the flow rate of the dopant gas. The dopant gas is, for example, a nitrogen gas.

The fifth mass flow controller 29 is provided in the assist gas supply pipe 19. The fifth mass flow controller 29 has a function of monitoring the flow rate of the assist gas supplied to the reactor 10 and controlling the flow rate of the assist gas. The assist gas is, for example, a hydrogen chloride gas.

The exhaust pipe 30 is connected to the reactor 10. The exhaust pipe 30 has a function of discharging the process gas from the reactor 10.

The pressure adjusting valve 31 has a function of adjusting the pressure in the reactor 10 to a desired pressure by controlling the flow rate of the process gas discharged from the reactor 10. The pressure adjusting valve 31 is, for example, a throttle valve or a butterfly valve.

The exhaust pump 32 has a function of discharging the gas from the reactor 10. The exhaust pump 32 is, for example, a vacuum pump.

The control unit 34 controls the operation of the vapor phase growth apparatus 100. The control unit 34 controls, for example, the operations of the first mass flow controller 25, the second mass flow controller 26, the third mass flow controller 27, the fourth mass flow controller 28, the fifth mass flow controller 29, the pressure adjusting valve 31, and the exhaust pump 32.

The control unit 34 is, for example, a control circuit. The control unit 34 is, for example, an electronic circuit. The control unit 34 includes, for example, hardware and software.

The control unit 34 includes the process condition storage unit 34a, the average residence time calculation unit 34b, the transition time determination unit 34c, the flow rate instruction unit 34d, and the valve opening instruction unit 34e.

The process condition storage unit 34a has, for example, a function of storing the process conditions when forming the silicon carbide layer on the wafer W. The process conditions are, for example, the gas conditions, wafer temperature, reactor pressure, or duration of each process step when forming the silicon carbide layer. The gas conditions are, for example, a gas type or a gas flow rate. The process condition storage unit 34a stores, for example, a reactor volume.

The process condition storage unit 34a is, for example, a memory device. The process condition storage unit 34a is, for example, a semiconductor memory.

The average residence time calculation unit 34b has a function of calculating an average residence time tx in the reactor 10 of the carrier gas. The average residence time tx of the carrier gas in the reactor 10 means an average time from when the carrier gas is supplied into the reactor 10 to when the carrier gas is discharged to the outside of the reactor 10. The average residence time tx is expressed by the following equation, for example. In addition, the carrier gas flow rate may be approximately used as an exhaust flow rate, and the same applies to the following description. In addition, the reactor volume in the following equation is obtained by subtracting the volume occupied by various components arranged in the reactor from the volume of the space surrounded by the wall surface of the reactor 10, and the same applies to the following description.

$$tx = reactor\ pressure\ [Pa] \times reactor\ volume\ [m^3]/carrier\ gas\ flow\ rate\ [Pa{\cdot}m^3/s]$$

For example, the average residence time calculation unit 34b calculates the average residence time tx from the carrier gas flow rate, the reactor pressure, and the reactor volume stored in the process condition storage unit 34a.

The average residence time calculation unit 34b is, for example, an average residence time calculation circuit. The average residence time calculation unit 34b is, for example, an electronic circuit. The average residence time calculation unit 34b includes, for example, hardware and software.

The transition time determination unit 34c has, for example, a function of determining a transition time t required for transitioning from one process step to the next process step when forming a silicon carbide layer. The transition time determination unit 34c has, for example, a function of determining the length of the transition time t when the flow rate of the source gas supplied to the reactor 10 is switched at the transition time t. The transition time t is, for example, a time required from the start of the change of the flow rate of the source gas to the end of the change.

For example, the transition time determination unit 34c determines the transition time t so that the average residence time tx in the reactor 10 of the carrier gas is shorter than the transition time t. The transition time determination unit 34c determines the transition time t based on the average residence time tx of the carrier gas calculated by the average residence time calculation unit 34b.

The flow rate instruction unit 34d has a function of giving an instruction regarding the gas flow rate to the first mass flow controller 25, the second mass flow controller 26, the third mass flow controller 27, the fourth mass flow controller 28, and the fifth mass flow controller 29, for example.

The flow rate instruction unit 34d is, for example, a flow rate instruction circuit. The flow rate instruction unit 34d is, for example, an electronic circuit. The flow rate instruction unit 34d includes, for example, hardware and software.

The valve opening instruction unit 34e has, for example, a function of giving an instruction regarding a predetermined opening to the pressure adjusting valve 31 so that the reactor pressure is maintained at the pressure stored in the process condition storage unit 34a.

The valve opening instruction unit 34e is, for example, a valve opening instruction circuit. The valve opening instruction unit 34e is, for example, an electronic circuit. The valve opening instruction unit 34e includes, for example, hardware and software.

The control unit 34 controls the first mass flow controller 25, the second mass flow controller 26, the third mass flow controller 27, and the pressure adjusting valve 31, for example, so that the average residence time tx in the reactor 10 of the carrier gas expressed by the following equation is shorter than the transition time t when switching the flow rate of at least one of the first source gas and the second source gas supplied to the reactor 10 at the transition time t.

$$tx = reactor\ pressure\ [Pa] \times reactor\ volume\ [m^3]/carrier\ gas\ flow\ rate\ [Pa{\cdot}m^3/s]$$

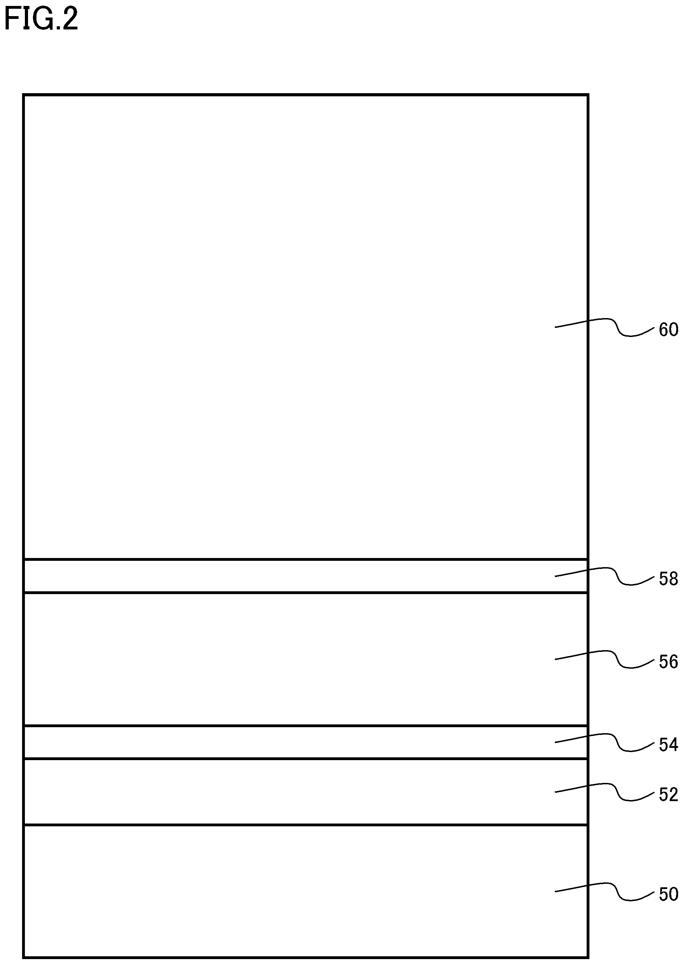

Fig. 2 is a schematic cross-sectional view of an example of a silicon carbide layer formed by a vapor phase growth method of embodiments. The silicon carbide layer formed by the vapor phase growth method of embodiments is formed on a silicon carbide substrate 50. The silicon carbide substrate 50 is an example of a substrate.

The silicon carbide layer formed by the vapor phase growth method of embodiments includes a first buffer layer 52, a first transition layer 54, a second buffer layer 56, a second transition layer 58, and a drift layer 60.

The silicon carbide substrate 50 (substrate), the first buffer layer 52 (first silicon carbide layer), the first transition layer 54, the second buffer layer 56 (second silicon carbide layer), the second transition layer 58, and the drift layer 60 (third silicon carbide layer) are single crystal 4H-SiC silicon carbide. The silicon carbide substrate 50, the first buffer layer 52, the first transition layer 54, the second buffer layer 56, the second transition layer 58, and the drift layer 60 contain nitrogen (N) that is an n-type impurity as a dopant.

The silicon carbide substrate 50 is an example of a substrate. The first buffer layer 52 is an example of the first silicon carbide layer. The second buffer layer 56 is an example of the second silicon carbide layer. The drift layer 60 is an example of the third silicon carbide layer.

The nitrogen concentration of the silicon carbide substrate 50 is, for example, equal to or more than $1E18/cm^3$ and equal to or less than $2E19/cm^3$. The thickness of the silicon carbide substrate 50 is, for example, equal to or more than 300 $\mu$m and equal to or less than 500 $\mu$m.

The first buffer layer 52 is provided on the silicon carbide substrate 50. The first buffer layer 52 has, for example, a function of improving the crystallinity of the drift layer 60.

The nitrogen concentration of the first buffer layer 52 is, for example, equal to or more than $1E17/cm^3$ and equal to or less than $2E19/cm^3$. The nitrogen concentration of the first buffer layer 52 is lower than, for example, the nitrogen concentration of the silicon carbide substrate 50. The thickness of the first buffer layer 52 is, for example, equal to or more than 0.05 $\mu$m and equal to or less than 0.50 $\mu$m.

The first transition layer 54 is provided on the first buffer layer 52. The first transition layer 54 is provided between the first buffer layer 52 and the second buffer layer 56.

The nitrogen concentration of the first transition layer 54 is, for example, equal to or more than $1E17/cm^3$ and equal to or less than $2E19/cm^3$. The thickness of the first transition layer 54 is, for example, equal to or more than 0.01 $\mu$m and equal to or less than 0.15 $\mu$m.

The second buffer layer 56 is provided on the first transition layer 54. The second buffer layer 56 has, for example, a function of improving the crystallinity of the drift layer 60.

The nitrogen concentration of the second buffer layer 56 is, for example, equal to or more than $1E17/cm^3$ and equal to or less than $2E19/cm^3$. The nitrogen concentration of the second buffer layer 56 is lower than, for example, the nitrogen concentration of the silicon carbide substrate 50. The thickness of the second buffer layer 56 is, for example, equal to or more than 0.5 $\mu$m and equal to or less than 5 $\mu$m.

The second transition layer 58 is provided on the second buffer layer 56. The second transition layer 58 is provided between the second buffer layer 56 and the drift layer 60.

The nitrogen concentration of the second transition layer 58 is, for example, equal to or more than $1E13/cm^3$ and equal to or less than $2E19/cm^3$. The thickness of the second transition layer 58 is, for example, equal to or more than 0.01 $\mu$m and equal to or less than 0.15 $\mu$m.

The drift layer 60 is provided on the second transition layer 58. A semiconductor device is formed in or on the drift layer 60.

The nitrogen concentration of the drift layer 60 is lower than the nitrogen concentration of the first buffer layer 52 and the nitrogen concentration of the second buffer layer 56. The nitrogen concentration of the drift layer 60 is, for example, equal to or more than $1E13/cm^3$ and equal to or less than $2E16/cm^3$. The thickness of the drift layer 60 is, for example, equal to or more than 5 $\mu$m and equal to or less than 500 $\mu$m.

Next, an example of the vapor phase growth method of embodiments will be described. In the vapor phase growth method of embodiments, the vapor phase growth apparatus 100 shown in Fig. 1 is used.

Hereinafter, a case where a single crystal 4H-SiC silicon carbide layer doped with nitrogen as an n-type impurity is formed on the surface of the silicon carbide substrate 50 will be described as an example. In addition, hereinafter, a case where the carrier gas is a hydrogen gas, the first source gas is a monosilane gas, the second source gas is a propane gas, the dopant gas is a nitrogen gas, and the assist gas is a hydrogen chloride gas when forming the silicon carbide layer will be described as an example.

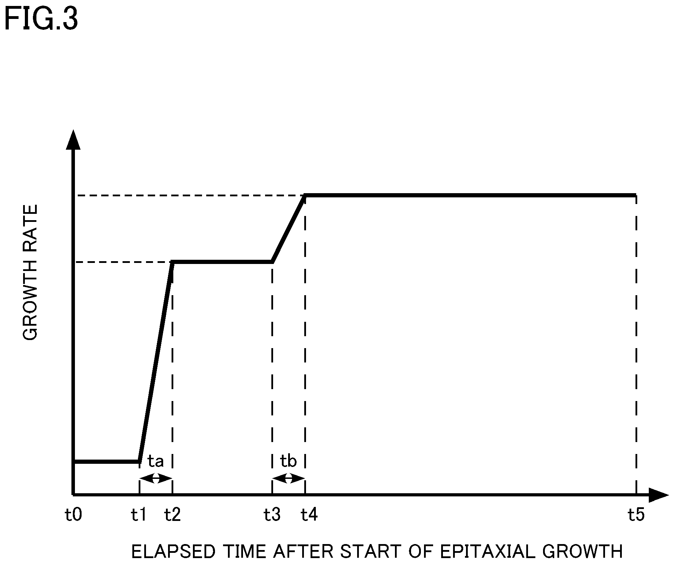

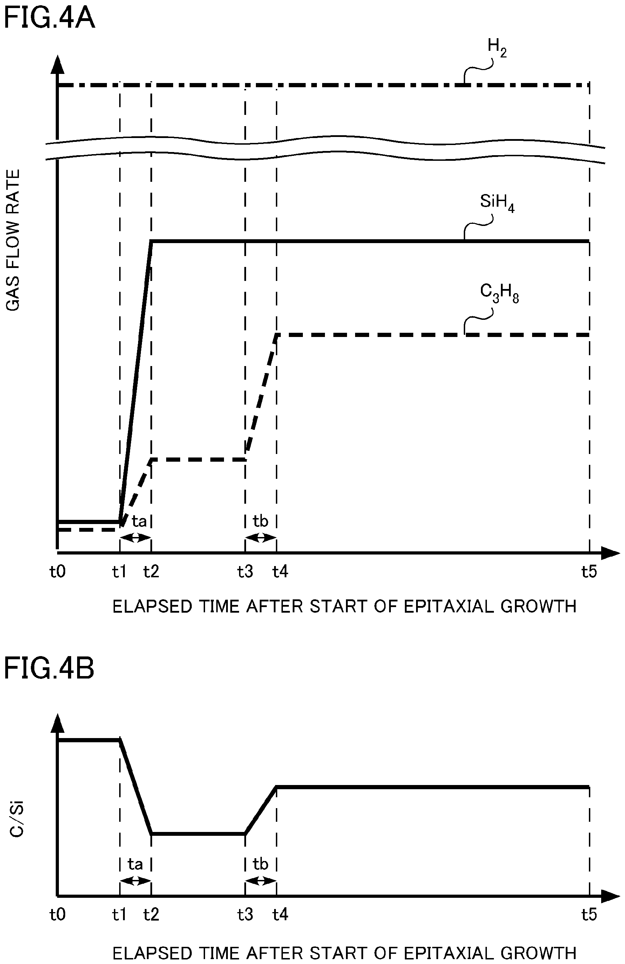

Figs. 3, 4A, and 4B are explanatory diagram of the vapor phase growth method of embodiments. Fig. 3 is a diagram showing the time change of the growth rate of the silicon carbide layer when the silicon carbide layer is formed. Fig. 4A is a diagram showing the time change of the gas flow rate of the process gas when forming the silicon carbide layer. Fig. 4B is a diagram showing the time change of the carbon/silicon atom ratio (C/Si) in the process gas when forming the silicon carbide layer.

The vapor phase growth method of embodiments includes a first process step of forming the first buffer layer 52, a second process step of forming the first transition layer 54, a third process step of forming the second buffer layer 56, a fourth process step of forming the second transition layer 58, and a fifth process step of forming the drift layer 60. The first process step, the second process step, the third process step, the fourth process step, and the fifth process step are continuously performed in the same reactor 10 without taking the substrate out of the reactor 10.

First, the susceptor 12 on which the wafer W is placed is loaded into the reactor 10. The wafer W is the silicon carbide substrate 50. The wafer W is an example of a substrate.

The nitrogen concentration of the silicon carbide substrate 50 is, for example, equal to or more than $1E18/cm^3$ and equal to or less than $2E19/cm^3$.

Then, the wafer W is heated by using the heater 14. The temperature of the wafer W is, for example, equal to or more than 1550°C and equal to or less than 1750°C.

In the first process step, the first buffer layer 52 is formed on the wafer W. The first buffer layer 52 has a first nitrogen concentration. The first buffer layer 52 is formed by supplying a first process gas containing a carrier gas into the reactor 10 under the first gas condition. The first buffer layer 52 is formed at the first growth rate. The first buffer layer 52 is formed between time t0 and time t1.

The first nitrogen concentration is, for example, equal to or more than $1E17/cm^3$ and equal to or less than $2E19/cm^3$.

The first gas condition includes, for example, the type of process gas supplied into the reactor 10 and the flow rate of each process gas in the first process step.

In the first process step, a hydrogen gas, a monosilane gas, a propane gas, a nitrogen gas, and a hydrogen chloride gas having a predetermined flow rate are supplied into the reactor 10 as the first process gas.

The first growth rate is, for example, equal to or more than 1 μm/h and equal to or less than 10 μm/h. The first growth rate depends, for example, on a silicon/hydrogen atom ratio (Si/H) in the process gas. The first growth rate depends, for example, on the ratio between the flow rate of the monosilane gas and the flow rate of the hydrogen gas in the process gas. The silicon/hydrogen atom ratio (Si/H) in the first process step is, for example, equal to or more than 5.28E-5 and equal to or less than 4.65E-4.

The carbon/silicon atom ratio (C/Si) under the first gas condition is, for example, equal to or more than 0.5 and equal to or less than 3.5. The chlorine/silicon atom ratio (Cl/Si) under the first gas condition is, for example, equal to or more than 1 and equal to or less than 30.

The thickness of the first buffer layer 52 is, for example, equal to or more than 0.05 μm and equal to or less than 0.50 μm.

In the second process step, the first transition layer 54 is formed on the first buffer layer 52. The first transition layer 54 is formed between time t1 and time t2. The difference between the time t2 and the time t1 is a first transition time ta.

The thickness of the first transition layer 54 is, for example, less than the thickness of the first buffer layer 52.

In the third process step, the second buffer layer 56 is formed on the first transition layer 54. The second buffer layer 56 has a second nitrogen concentration. The second buffer layer 56 is formed by supplying a second process gas containing a carrier gas into the reactor 10 under the second gas condition. The second buffer layer 56 is formed at the second growth rate. The second buffer layer 56 is formed between time t2 and time t3.

The second nitrogen concentration is, for example, equal to or more than $1E17/cm^3$ and equal to or less than $2E19/cm^3$.

The second gas condition includes, for example, the type of process gas supplied into the reactor 10 and the flow rate of each process gas in the third process step.

In the third process step, a hydrogen gas, a monosilane gas, a propane gas, a nitrogen gas, and a hydrogen chloride gas having a predetermined flow rate are supplied into the reactor 10 as process gases.

As shown in Fig. 3, the second growth rate is larger than the first growth rate. The second growth rate is, for example, equal to or more than 40 μm/h and equal to or less than 100 μm/h. The second growth rate depends, for example, on a silicon/hydrogen atom ratio (Si/H) in the process gas. The second growth rate depends, for example, on the ratio between the flow rate of the monosilane gas and the flow rate of the hydrogen gas in the process gas. The silicon/hydrogen atom ratio (Si/H) in the third process step is, for example, equal to or more than 5.28E-4 and equal to or less than 4.65E-3.

As shown in Fig. 4A, the flow rate of the monosilane gas under the second gas condition is larger than the flow rate of the monosilane gas under the first gas condition. In addition, the silicon/hydrogen atom ratio (Si/H) in the second process gas under the second gas condition is larger than the silicon/hydrogen atom ratio (Si/H) in the first process gas under the first gas condition. Since the silicon/hydrogen atom ratio (Si/H) under the second gas condition is larger than the silicon/hydrogen atom ratio (Si/H) under the first gas condition, the second growth rate tends to be larger than the first growth rate. In addition, the flow rate of the hydrogen gas under the second gas condition is, for example, equal to the flow rate of the hydrogen gas under the first gas condition. In addition, the flow rate of the hydrogen gas under the second gas condition may be adjusted in the range of 0.90 times to 1.10 times the flow rate of the hydrogen gas under the first gas condition, for example.

As shown in Fig. 4A, the flow rate of the propane gas under the second gas condition is larger than the flow rate of the propane gas under the first gas condition.

The carbon/silicon atom ratio (C/Si) in the second process gas under the second gas condition is, for example, equal to or more than 0.5 and equal to or less than 2.0. The chlorine/silicon atom ratio (Cl/Si) in the second process gas under the second gas condition is, for example, equal to or more than 1 and equal to or less than 30.

As shown in Fig. 4B, for example, the carbon/silicon atom ratio (C/Si) in the second process gas under the second gas condition is smaller than the carbon/silicon atom ratio (C/Si) in the first process gas under the first gas condition.

The thickness of the second buffer layer 56 is, for example, equal to or more than 0.5 $\mu$m and equal to or less than 5 $\mu$m.

In the second process step, the gas condition are switched from the first gas condition to the second gas condition. In the second process step, the gas condition are switched from the first gas condition to the second gas condition during the first transition time ta. The first transition time ta is a time required from the start of the change of the first gas condition to the end of the change to the second gas condition.

As shown in Fig. 4A, in the second process step, for example, the flow rate of the monosilane gas changes in a direction of increasing. In addition, as shown in Fig. 4A, in the second process step, for example, the flow rate of the propane gas changes in a direction of increasing. In the second process step, for example, the flow rate of the hydrogen gas is equal to the flow rate of the hydrogen gas under the first gas condition. In addition, for example, the flow rate of the hydrogen gas may be adjusted in the range of 0.90 times to 1.10 times the flow rate of the hydrogen gas under the first gas condition.

In the second process step of forming the first transition layer 54, the average residence time tx in the reactor 10 of the hydrogen gas is set to be shorter than the first transition time ta. The average residence time tx in the reactor 10 of the hydrogen gas is expressed by the following equation.

$$tx = \text{reactor pressure [Pa]} \times \text{reactor volume} \\ [m^3]/\text{carrier gas flow rate [Pa·}m^3\text{/s]}$$

In the second process step, the average residence time tx in the reactor 10 of the hydrogen gas is, for example, equal to or more than 0.5 seconds and equal to or less than 10 seconds.

In the fourth process step, the second transition layer 58 is formed on the second buffer layer 56. The second transition layer 58 is formed between time t3 and time t4. The difference between the time t3 and the time t4 is a second transition time tb.

The thickness of the second transition layer 58 is, for example, less than the thickness of the second buffer layer 56.

In the fifth process step, the drift layer 60 is formed on the second transition layer 58. The drift layer 60 has a third nitrogen concentration. The drift layer 60 is formed by supplying a third process gas containing a carrier gas into the reactor 10 under the third gas condition. The drift layer 60 is formed at a third growth rate. The drift layer 60 is formed between time t4 and time t5.

The third nitrogen concentration is lower than the first nitrogen concentration and the second nitrogen concentration. The third nitrogen concentration is, for example, equal to or more than $1E13/cm^3$ and equal to or less than $2E16/cm^3$.

The third gas condition are, for example, the type of process gas supplied into the reactor 10 and the flow rate of each process gas in the fifth process step.

In the fifth process step, a hydrogen gas, a monosilane gas, a propane gas, a nitrogen gas, and a hydrogen chloride gas having a predetermined flow rate are supplied into the reactor 10 as process gases.

As shown in Fig. 3, the third growth rate is larger than the second growth rate. The third growth rate is, for example, equal to or more than 45 $\mu$m/h and equal to or less than 100 $\mu$m/h. The third growth rate depends, for example, on a silicon/hydrogen atom ratio (Si/H) in the process gas. The third growth rate depends, for example, on the ratio between the flow rate of the monosilane gas and the flow rate of the hydrogen gas in the process gas. The silicon/hydrogen atom ratio (Si/H) in the fifth process step is, for example, equal to or more than 5.28E-4 and equal to or less than 4.65E-3.

As shown in Fig. 4A, the flow rate of the monosilane gas under the third gas condition is preferably equal to the flow rate of the monosilane gas under the second gas condition, but may be adjusted in the range of 0.95 times to 1.40 times the flow rate of the monosilane gas under the second gas condition. In addition, for example, the flow rate of the hydrogen gas under the third gas condition is equal to the flow rate of the hydrogen gas under the second gas condition. In addition, for example, the flow rate of the hydrogen gas under the third gas condition may be adjusted in the range of 0.90 times to 1.10 times the flow rate of the hydrogen gas under the second gas condition.

As shown in Fig. 4A, the flow rate of the propane gas under the third gas condition is larger than the flow rate of the propane gas under the second gas condition.

The carbon/silicon atom ratio (C/Si) under the third gas condition is, for example, equal to or more than 0.5 and equal to or less than 2.0. The chlorine/silicon atom ratio (Cl/Si) under the third gas condition is, for example, equal to or more than 1 and equal to or less than 30.

As shown in Fig. 4B, for example, the carbon/silicon atom ratio (C/Si) in the third process gas under the third gas condition is larger than the carbon/silicon atom ratio (C/Si) in the second process gas under the second gas condition. For example, by making the carbon/silicon atom ratio (C/Si) under the third gas condition larger than the carbon/silicon atom ratio (C/Si) under the second gas condition, the third growth rate can be made larger than the second growth rate.

The thickness of the drift layer 60 is, for example, equal to or more than 5 $\mu$m and equal to or less than 500 $\mu$m.

In the fourth process step, the gas condition are switched from the second gas condition to the third gas condition. In the fourth process step, the gas condition are switched from the second gas condition to the third gas condition during the second transition time tb. The second transition time tb is a time required from the start of the change of the second gas condition to the end of the change to the third gas condition.

As shown in Fig. 4A, in the fourth process step, for example, the flow rate of the propane gas changes in a direction of increasing.

In the fourth process step of forming the second transition layer 58, the average residence time tx in the reactor 10 of the hydrogen gas is set to be shorter than the second transition time tb. The average residence time tx in the reactor 10 of the hydrogen gas is expressed by the following equation.

$$tx = reactor\ pressure\ [Pa] \times reactor\ volume\ [m^3]/carrier\ gas\ flow\ rate\ [Pa{\cdot}m^3/s]$$

In the fourth process step, the average residence time tx in the reactor 10 of the hydrogen gas is, for example, equal to or more than 0.5 seconds and equal to or less than 10 seconds.

The silicon carbide layer shown in Fig. 2 is formed by the vapor phase growth method described above.

Next, the function and effect of the vapor phase growth method and the vapor phase growth apparatus of embodiments will be described.

When a silicon carbide layer is formed on a substrate by using the epitaxial growth technique, a crystal defect is generated in the silicon carbide layer. Examples of the crystal defect include basal plane dislocation (BPD) and stacking fault (SF). If a crystal defect is present in the silicon carbide layer, for example, the reliability of the semiconductor device formed on the silicon carbide layer is reduced, which causes a problem. Therefore, it is desired to reduce the crystal defect density in the silicon carbide layer.

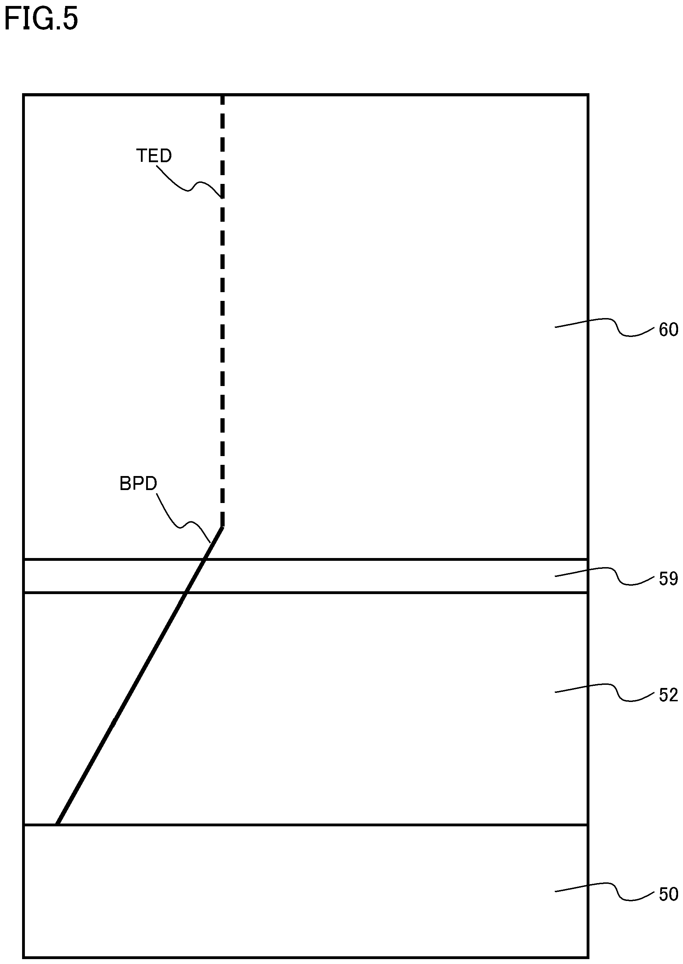

Fig. 5 is a schematic cross-sectional view of a silicon carbide layer formed by a vapor phase growth method of a first comparative example. The vapor phase growth method of the first comparative example is different from the vapor phase growth method of embodiments in that the second buffer layer 56 is not formed between the first buffer layer 52 and the drift layer 60. That is, the vapor phase growth method of the first comparative example is different from the vapor phase growth method of embodiments in that the second buffer layer 56 having a higher growth rate than the first buffer layer 52 is not formed between the first buffer layer 52 and the drift layer 60. In addition, in Fig. 5, a defect present in the silicon carbide substrate 50 is not shown.

A transition layer 59 is formed between the first buffer layer 52 and the drift layer 60.

As shown in Fig. 5, according to the vapor phase growth method of the first comparative example, for example, it is easy to suppress the formation of a stacking fault SF from the interface between the silicon carbide substrate 50 and the first buffer layer 52. Therefore, it is possible to suppress the formation of the stacking fault SF extending to the drift layer 60. The stacking fault SF in the drift layer 60 grows, for example, during the bipolar operation of the semiconductor device, and increases the electrical resistance of the drift layer 60. Therefore, the stacking fault SF reduces the reliability of the semiconductor device, which causes a problem.

According to the vapor phase growth method of the first comparative example, it is possible to suppress the formation of the stacking fault SF extending to the drift layer 60. Therefore, it is possible to suppress the reduction of the reliability of the semiconductor device due to the stacking fault SF formed by the epitaxial growth.

On the other hand, in the vapor phase growth method of the first comparative example, the basal plane dislocation BPD that reaches the surface of the silicon carbide substrate 50 from the inside of the silicon carbide substrate 50 is likely to be propagated to the first buffer layer 52 to reach the surface of the first buffer layer 52. In addition, the basal plane dislocation BPD that reaches the surface of the first buffer layer 52 is likely to be propagated to the vicinity of the first buffer layer 52 in the drift layer 60. The basal plane dislocation BPD propagating to the vicinity of the first buffer layer 52 in the drift layer 60 is converted into a threading edge dislocation (TED) in the drift layer 60, for example.

As described above, the basal plane dislocation BPD is easily converted into the threading edge dislocation TED in the vicinity of the first buffer layer 52 in the drift layer 60. That is, the basal plane dislocation BPD is present up to the vicinity of the first buffer layer 52 in the drift layer 60. When the basal plane dislocation BPD is present in the drift layer 60, for example, the basal plane dislocation BPD is converted into the stacking fault SF during the bipolar operation of the semiconductor device. The stacking fault SF increases the electrical resistance of the drift layer 60, for example.

Therefore, the reliability of the semiconductor device is reduced, which causes a problem.

As described above, according to the vapor phase growth method of the first comparative example, it is possible to reduce the density of the stacking fault SF in the drift layer 60 formed by the epitaxial growth. On the other hand, in the vapor phase growth method of the first comparative example, it is difficult to reduce the density of the basal plane dislocation BPD extending to the vicinity of the first buffer layer 52 in the drift layer 60. Therefore, in the vapor phase growth method of the first comparative example, the reduction of the reliability of the semiconductor device due to the basal plane dislocation BPD or the stacking fault SF formed by being converted from the basal plane dislocation BPD becomes a problem.

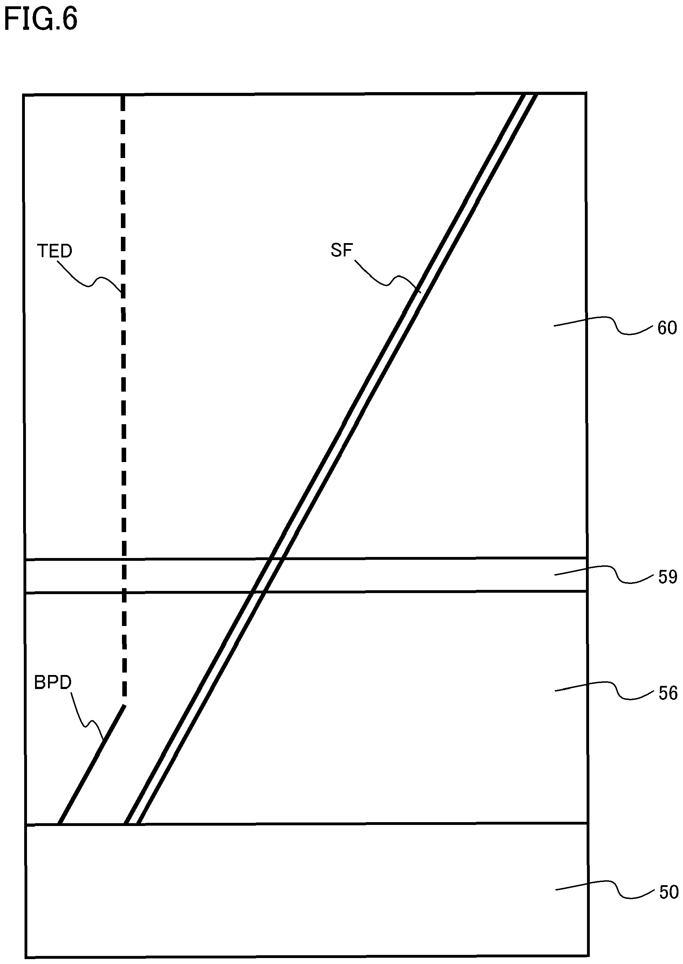

Fig. 6 is a schematic cross-sectional view of a silicon carbide layer formed by a vapor phase growth method of a second comparative example. The vapor phase growth method of the second comparative example is different from the vapor phase growth method of embodiments in that the first buffer layer 52 is not formed between the silicon carbide substrate 50 and the second buffer layer 56. That is, the vapor phase growth method of the second comparative example is different from the vapor phase growth method of embodiments in that the first buffer layer 52 having a lower growth rate than the second buffer layer 56 is not formed between the silicon carbide substrate 50 and the second buffer layer 56. In addition, in Fig. 6, a defect present in the silicon carbide substrate 50 is not shown.

A transition layer 59 is formed between the second buffer layer 56 and the drift layer 60.

As shown in Fig. 6, according to the vapor phase growth method of the second comparative example, for example, the basal plane dislocation BPD extending from the interface between the silicon carbide substrate 50 and the second buffer layer 56 is likely to be converted into the threading edge dislocation TED in the second buffer layer 56. Therefore, it is possible to reduce the density of the basal plane dislocation BPD in the drift layer 60.

In addition, it is known that the influence of the threading edge dislocation TED on the characteristics of the semiconductor device is minor as compared with, for example, the basal plane dislocation BPD and the stacking fault SF.

According to the vapor phase growth method of the second comparative example, it is possible to reduce the density of the basal plane dislocation BPD in the drift layer 60. Therefore, it is possible to suppress the reduction of the reliability of the semiconductor device due to the basal plane dislocation BPD.

On the other hand, as shown in Fig. 6, in the vapor phase growth method of the second comparative example, the stacking fault SF is likely to be formed from the interface between the silicon carbide substrate 50 and the second buffer layer 56. For this reason, it is difficult to suppress the formation of the stacking fault SF extending to the drift layer 60. Therefore, the reduction of the reliability of the semiconductor device due to the stacking fault SF becomes a problem.

As described above, according to the vapor phase growth method of the second comparative example, it is possible to reduce the density of the basal plane dislocation BPD in the drift layer 60 formed by the epitaxial growth. Therefore, it is possible to suppress the reduction of the reliability of the characteristics of the semiconductor device due to the basal plane dislocation BPD. On the other hand, in the vapor phase growth method of the second comparative example, it is difficult to reduce the density of the stacking fault SF extending to the drift layer 60. Therefore, in the vapor phase growth method of the second comparative example, the reduction of the reliability of the semiconductor device due to the stacking fault SF becomes a problem.

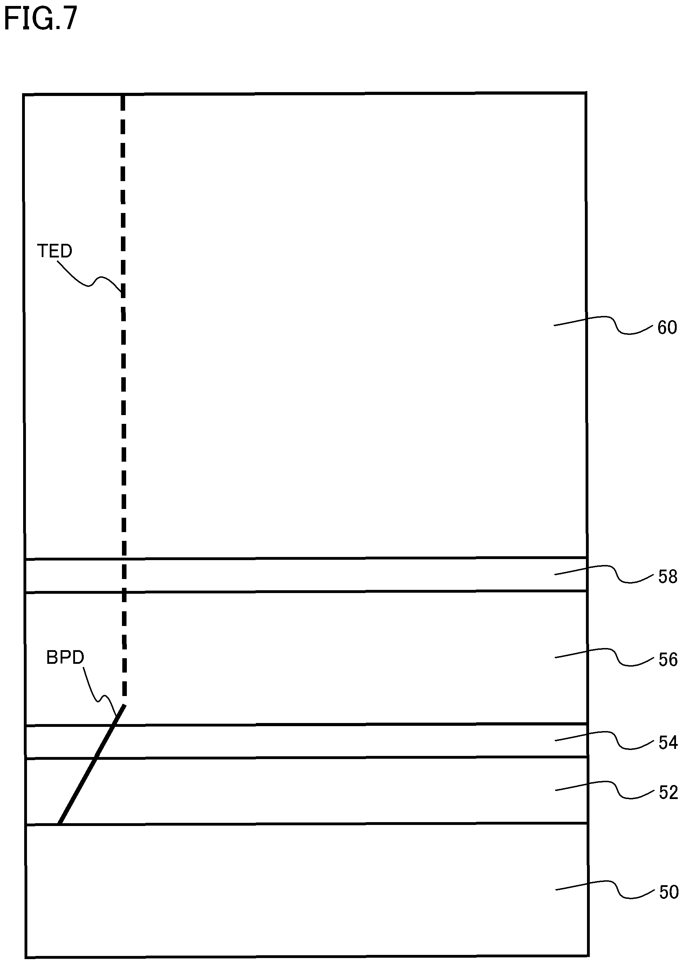

Fig. 7 is an explanatory diagram of the function and effect of the vapor phase growth method of embodiments. Fig. 7 is a schematic cross-sectional view of an example of the silicon carbide layer formed by the vapor phase growth method of embodiments.

In the vapor phase growth method of embodiments, the first buffer layer 52 is formed at the first growth rate before the drift layer 60 is formed on the silicon carbide substrate 50, and then the second buffer layer 56 is formed at the second growth rate higher than the first growth rate. By forming the first buffer layer 52, it is easy to suppress the formation of the stacking fault SF from the interface between the silicon carbide substrate 50 and the first buffer layer 52. Therefore, it is possible to reduce the density of the stacking fault SF extending into the drift layer 60. In addition, by forming the second buffer layer 56, the basal plane dislocation BPD that reaches the surface of the silicon carbide substrate 50 from the inside of the silicon carbide substrate 50 is easily converted into the threading edge dislocation TED in the second buffer layer 56, so that it is possible to reduce the density of the basal plane dislocation BPD in the drift layer 60. As a result, it is possible to reduce the densities of both the stacking fault SF and the basal plane dislocation BPD in the drift layer 60. Therefore, according to the vapor phase growth method of embodiments, it is possible to suppress the reduction of the reliability of the semiconductor device due to crystal defects.

The first growth rate when forming the first buffer layer 52 is preferably equal to or more than 1 μm/h and equal to or less than 10 μm/h, more preferably equal to or more than 2 μm/h and equal to or less than 8 μm/h, and even more preferably equal to or more than 3 μm/h and equal to or less than 6 μm/h. By making the first growth rate exceed the lower limit value described above, the time required for forming the first buffer layer 52 is shortened. As a result, the productivity of the silicon carbide layer is improved. In addition, by making the first growth rate fall below the upper limit value described above, the density of the stacking fault SF in the drift layer 60 can be further reduced.

From the viewpoint of setting the first growth rate when forming the first buffer layer 52 to be equal to or more than 1 μm/h and equal to or less than 10 μm/h, it is preferable that the silicon/hydrogen atom ratio (Si/H) when forming the first buffer layer 52 is equal to or more than 5.28E-5 and equal to or less than 4.65E-4.

The second growth rate when forming the second buffer layer 56 is preferably equal to or more than 40 μm/h and equal to or less than 100 μm/h, more preferably equal to or more than 45 μm/h and equal to or less than 80 μm/h, and even more preferably equal to or more than 50 μm/h and equal to or less than 60 μm/h. By making the second growth rate exceed the lower limit value described above, the density of the basal plane dislocation BPD in the drift layer 60 can be further reduced. In addition, by making the second growth rate fall below the upper limit value described above, the crystallinity or surface morphology of the drift layer 60 is improved.

From the viewpoint of setting the second growth rate when forming the second buffer layer 56 to be equal to or more than 40 μm/h and equal to or less than 100 μm/h, it is preferable that the silicon/hydrogen atom ratio (Si/H) when forming the second buffer layer 56 is equal to or more than 5.28E-4 and equal to or less than 4.65E-3.

The thickness of the first buffer layer 52 is preferably equal to or more than 0.05 μm and equal to or less than 0.5 μm. By making the thickness of the first buffer layer 52 exceed the lower limit value described above, the density of the stacking fault SF in the drift layer 60 can be further reduced. In addition, by making the thickness of the first buffer layer 52 fall below the upper limit value described above, the time required for forming the first buffer layer 52 is shortened. As a result, the productivity of the silicon carbide layer is improved.

The thickness of the second buffer layer 56 is preferably equal to or more than 0.5 μm and equal to or less than 5 μm. By making the thickness of the second buffer layer 56 exceed the lower limit value described above, the density of the basal plane dislocation BPD in the drift layer 60 can be further reduced. In addition, by making the thickness of the second buffer layer 56 fall below the upper limit value described above, the time required for forming the second buffer layer 56 is shortened. As a result, the productivity of the silicon carbide layer is improved.

The thickness of the second buffer layer 56 is preferably larger than the thickness of the first buffer layer 52. In other words, the thickness of the first buffer layer 52 is preferably smaller than the thickness of the second buffer layer 56. By reducing the thickness of the first buffer layer 52 having a low growth rate, the time required for forming the first buffer layer 52 is shortened. As a result, the productivity of the silicon carbide layer is improved.

In the second process step of forming the first transition layer 54, the average residence time tx in the reactor 10 of the hydrogen gas is preferably shorter than the first transition time ta. The average residence time tx in the reactor 10 of the hydrogen gas is expressed by the following equation.

$$tx = reactor\ pressure\ [Pa] \times reactor\ volume\ [m^3]/carrier\ gas\ flow\ rate\ [Pa \cdot m^3/s]$$

By making the average residence time tx in the reactor 10 of the hydrogen gas shorter than the first transition time ta, it becomes easy to control the film thickness or the doping concentration of the first transition layer 54.

In the fourth process step of forming the second transition layer 58, the average residence time tx in the reactor 10 of the hydrogen gas is preferably shorter than the second transition time tb. The average residence time tx in the reactor 10 of the hydrogen gas is expressed by the following equation.

$$tx = reactor\ pressure\ [Pa] \times reactor\ volume\ [m^3]/carrier\ gas\ flow\ rate\ [Pa \cdot m^3/s]$$

By making the average residence time tx in the reactor 10 of the hydrogen gas shorter than the second transition time tb, it becomes easy to control the film thickness or the doping concentration of the second transition layer 58.

The average residence time tx in the reactor 10 of the hydrogen gas is preferably equal to or more than 0.5 seconds and equal to or less than 10 seconds from the viewpoint of suppressing the formation of step bunching of the silicon carbide layer. In addition, the average residence time tx in the reactor 10 of the hydrogen gas is preferably equal to or less than 10 seconds from the viewpoint of reducing the thickness of the first transition layer 54 and the thickness of the second transition layer 58.

The carbon/silicon atom ratio (C/Si) under the second gas condition when forming the second buffer layer 56 is preferably smaller than the carbon/silicon atom ratio (C/Si) under the first gas condition when forming the first buffer layer 52. In other words, the carbon/silicon atom ratio (C/Si) under the first gas condition when forming the first buffer layer 52 is preferably larger than the carbon/silicon atom ratio (C/Si) under the second gas condition when forming the second buffer layer 56.

When forming a nitrogen-doped silicon carbide layer, it is possible to suppress the introduction of nitrogen into the silicon carbide layer by increasing the carbon/silicon atom ratio (C/Si) in the process gas. This is because the entry of nitrogen atoms into the carbon sites of silicon carbide is suppressed by increasing the carbon/silicon atom ratio (C/Si) in the process gas. Such a phenomenon occurs under the condition in which the carbon/silicon atom ratio (C/Si) in the process gas on the wafer surface exceeds 1.

The carbon/silicon atom ratio (C/Si) under the third gas condition when forming the drift layer 60 is preferably larger than the carbon/silicon atom ratio (C/Si) under the second gas condition when forming the second buffer layer 56.

By increasing the carbon/silicon atom ratio (C/Si) under the third gas condition when forming the drift layer 60, it is possible to reduce the density of carbon vacancies in the drift layer 60. The carbon vacancies serve as a minority carrier lifetime killer when operating a bipolar semiconductor device, for example. By reducing the density of carbon vacancies in the drift layer 60, it is possible to improve the characteristics of the bipolar semiconductor device.

In the vapor phase growth method of embodiments, the process gas when forming the first buffer layer 52, the first transition layer 54, the second buffer layer 56, the second transition layer 58, and the drift layer 60 preferable contains a hydrogen chloride (HCl) gas as an assist gas. Since the process gas contains a hydrogen chloride (HCl) gas, it is possible to suppress the generation of silicon droplets or the deterioration of the surface morphology of the silicon carbide layer. By suppressing the generation of silicon droplets or the deterioration of the surface morphology of the silicon carbide layer, for example, it is possible to reduce the crystal defect density in the silicon carbide layer.

The chlorine/silicon atom ratio (Cl/Si) in the process gas when forming the first buffer layer 52, the first transition layer 54, the second buffer layer 56, the second transition layer 58, and the drift layer 60 is preferably equal to or more than 1 and equal to or less than 30. When the chlorine/silicon atom ratio (Cl/Si) satisfies the above range, it is possible to further suppress the generation of silicon droplets or the deterioration of the surface morphology of the silicon carbide layer.

The vapor phase growth apparatus 100 of embodiments includes the control unit 34 that controls the first mass flow controller 25, the second mass flow controller 26, the third mass flow controller 27, and the pressure adjusting valve 31 so that the average residence time tx in the reactor 10 of the carrier gas expressed by the following equation is shorter than the transition time t when switching the flow rate of at least one of the first source gas and the second source gas supplied to the reactor 10 at the transition time t.

$$\mathtt{tx = reactor\ pressure\ [Pa] \times reactor\ volume}$$
$$\mathtt{[m^3]/carrier\ gas\ flow\ rate\ [Pa \cdot m^3/s]}$$

Since the vapor phase growth apparatus 100 of embodiments includes the control unit 34, it is easy to control the film thickness or the doping concentration of the transition layer.

As described above, according to the vapor phase growth method of embodiments, it is possible to reduce the crystal defect density in the silicon carbide layer. In addition, according to the vapor phase growth apparatus of embodiments, it is possible to improve the uniformity of the silicon carbide layer.

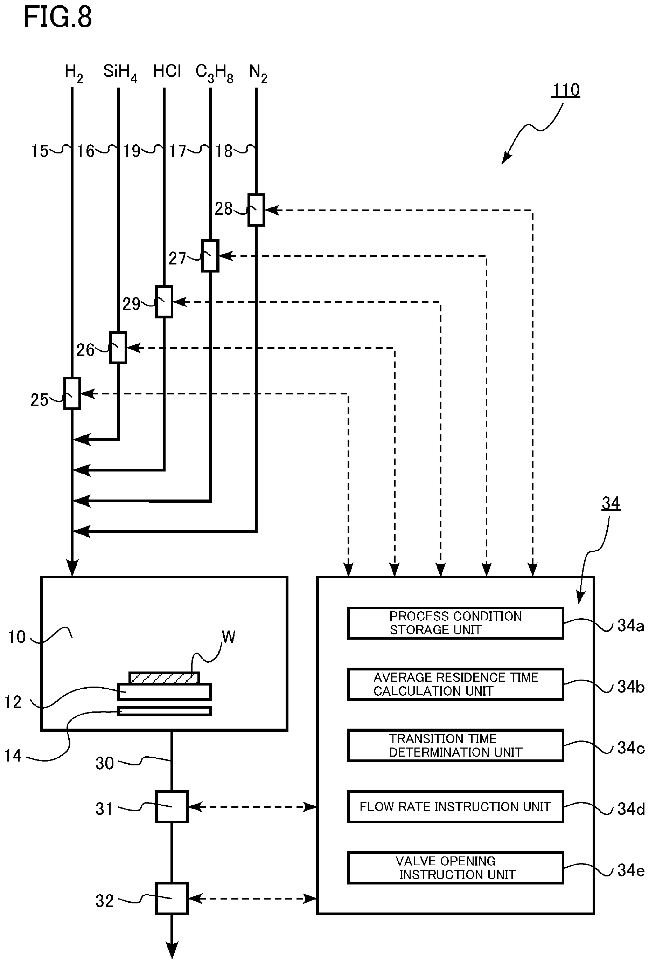

Fig. 8 is a schematic diagram of a first modification example of the vapor phase growth apparatus of embodiments. A vapor phase growth apparatus 110 of the first modification example shows another configuration example of the vapor phase growth apparatus 100 of embodiments.

The vapor phase growth apparatus 110 includes a reactor 10, a susceptor 12, a heater 14, a carrier gas supply pipe 15, a first source gas supply pipe 16, a second source gas supply pipe 17, a dopant gas supply pipe 18, an assist gas supply pipe 19, a first mass flow controller 25, a second mass flow controller 26, a third mass flow controller 27, a fourth mass flow controller 28, a fifth mass flow controller 29, an exhaust pipe 30, a pressure adjusting valve 31, an exhaust pump 32, and a control unit 34.

In the vapor phase growth apparatus 110 shown in Fig. 8, the first source gas supply pipe 16, the second source gas supply pipe 17, the dopant gas supply pipe 18, and the assist gas supply pipe 19 are connected to the carrier gas supply pipe 15. Thus, the carrier gas may be mixed with a gas, such as a source gas, a dopant gas, or an assist gas, to be introduced into the reactor 10.

In addition, in the vapor phase growth apparatus 110 shown in Fig. 8, the first source gas supply pipe 16, the second source gas supply pipe 17, the dopant gas supply pipe 18, and the assist gas supply pipe 19 may be connected to the reactor 10 through the carrier gas supply pipe 15. As described above, the first source gas supply pipe 16, the second source gas supply pipe 17, the dopant gas supply pipe 18, and the assist gas supply pipe 19 may be connected to the reactor 10 through the carrier gas supply pipe 15 by being connected to the carrier gas supply pipe 15.

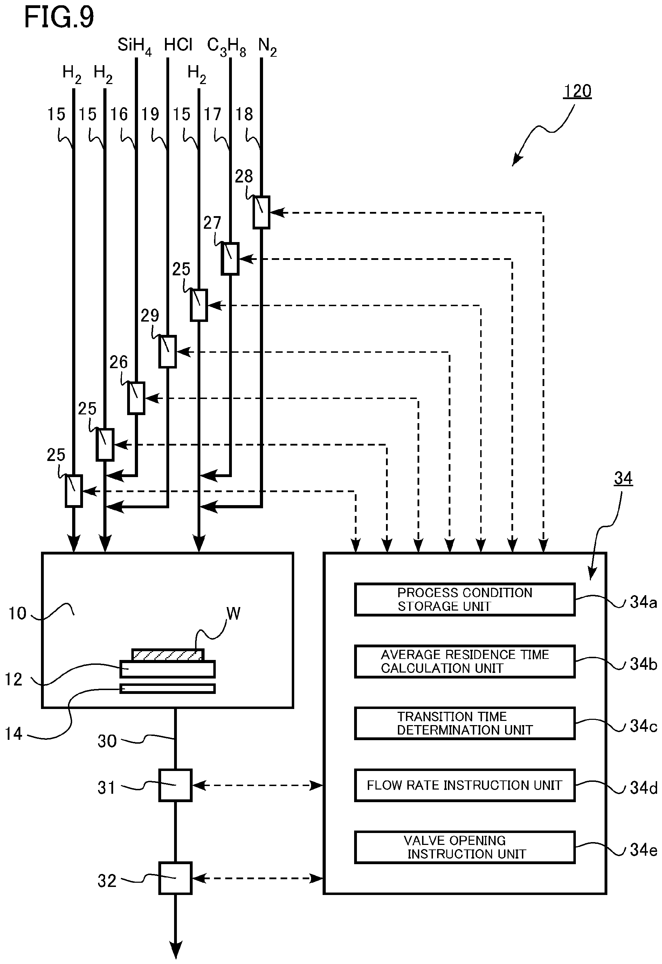

Fig. 9 is a schematic diagram of a second modification example of the vapor phase growth apparatus of embodiments. A vapor phase growth apparatus 120 of the second modification example shows still another configuration example of the vapor phase growth apparatus 100 of embodiments.

The vapor phase growth apparatus 120 includes a reactor 10, a susceptor 12, a heater 14, a carrier gas supply pipe 15, a first source gas supply pipe 16, a second source gas supply pipe 17, a dopant gas supply pipe 18, an assist gas supply pipe 19, a first mass flow controller 25, a second mass flow controller 26, a third mass flow controller 27, a fourth mass flow controller 28, a fifth mass flow controller 29, an exhaust pipe 30, a pressure adjusting valve 31, an exhaust pump 32, and a control unit 34.

In the vapor phase growth apparatus 120 shown in Fig. 9, a plurality of carrier gas supply pipes 15 are provided. Thus, a plurality of carrier gas supply pipes 15 may be connected to the reactor 10.

In the vapor phase growth apparatus 120 shown in Fig. 9, the first source gas supply pipe 16 and the assist gas supply pipe 19 are connected to one of the plurality of carrier gas supply pipes 15. The second source gas supply pipe 17 and the dopant gas supply pipe 18 are connected to another one of the plurality of carrier gas supply pipes 15. Still another one of the plurality of carrier gas supply pipes 15 is connected to the reactor 10 without being connected to the first source gas supply pipe 16, the second source gas supply pipe 17, the dopant gas supply pipe 18, and the assist gas supply pipe 19.

As described above, only the carrier gas may be introduced into the reactor 10, or the carrier gas may be mixed with a gas, such as a source gas, a dopant gas, or an assist gas, to be introduced into the reactor 10. In the vapor phase growth apparatus 120 shown in Fig. 9, each of the plurality of carrier gas supply pipes 15 includes the first mass flow controller 25. Thus, when a plurality of carrier gas supply pipes 15 are connected to the reactor 10, the first mass flow controller 25 may be provided in each carrier gas supply pipe 15.

In addition, since the vapor phase growth apparatus 100 of embodiments and the vapor phase growth apparatuses of the modification examples thereof include the control unit 34, it is possible to improve the uniformity of the transition layer and the silicon carbide layer close to the transition layer. In the control unit 34, since the average residence time tx can be easily calculated and the transition time t can be easily determined from the calculated average residence time tx, the transition time determination unit 34c is not always a necessary component.

Embodiments and the modification examples thereof have been described above with reference to the specific examples. Embodiments described above are merely given as examples, and are not limited. In addition, the components of embodiments may be combined as appropriate.

In embodiments and the modification examples thereof, the case where the carrier gas, the source gas, the dopant gas, and the assist gas are independently supplied into the reactor 10 (Fig. 1), the case where two or more of the carrier gas, the source gas, the dopant gas, and the assist gas are mixed (Fig. 9), the case where all of the carrier gas, the source gas, the dopant gas, and the assist gas are mixed to be supplied into the reactor 10 (Fig. 8), and the like have been described as examples. However, other methods may be used.

In embodiments and the modification examples thereof, the case where the silicon carbide layer contains an n-type impurity as a dopant has been described as an example. However, the silicon carbide layer may contain a p-type impurity as a dopant.

In embodiments and the modification examples thereof, the description of parts that are not directly required for the description of the inventions, such as the apparatus configuration or the manufacturing method, is omitted. However, the required apparatus configuration, manufacturing method, and the like can be appropriately selected and used. In addition, all vapor phase growth methods and vapor phase growth apparatuses that include the elements of the inventions and that can be appropriately redesigned by those skilled in the art are included in the scope of the inventions. The scope of the inventions is defined by the scope of claims and the scope of their equivalents.

**Claims**

1. A vapor phase growth method, comprising:

   forming a first silicon carbide layer (52) having a first doping concentration on a silicon carbide substrate (50) at a first growth rate by supplying a first process gas containing a carrier gas into a reactor (10) under a first gas condition;
   forming a second silicon carbide layer (56) having a second doping concentration at a second growth rate higher than the first growth rate by supplying a second process gas containing a carrier gas into the reactor (10) under a second gas condition after the forming the first silicon carbide layer (52); and
   forming a third silicon carbide layer (60) having a third doping concentration lower than the first doping concentration and the second doping concentration at a third growth rate higher than the second growth rate by supplying a third process gas containing a carrier gas into the reactor (10) under a third gas condition after the forming the second silicon carbide layer (56).

2. The vapor phase growth method according to claim 1,
   wherein a thickness of the second silicon carbide layer (56) is larger than a thickness of the first silicon carbide layer (52), and a thickness of the third silicon carbide layer (60) is larger than the thickness of the second silicon carbide layer (56).

3. The vapor phase growth method according to claim 1 further comprising:

forming a first transition layer (54) during a first transition time for switching from the first gas condition to the second gas condition after the forming the first silicon carbide layer (52); and
forming a second transition layer (58) during a second transition time for switching from the second gas condition to the third gas condition after the forming the second silicon carbide layer (56),
wherein an average residence time of the carrier gas in the reactor when forming the first transition layer (54) is shorter than the first transition time, and
wherein an average residence time of the carrier gas in the reactor when forming the second transition layer (58) is shorter than the second transition time.

4. The vapor phase growth method according to claim 1,

wherein a carbon/silicon atom ratio in the second process gas is smaller than a carbon/silicon atom ratio in the first process gas, and
a carbon/silicon atom ratio in the third process gas is larger than the carbon/silicon atom ratio in the second process gas.

5. The vapor phase growth method according to claim 1,
wherein a silicon/hydrogen atom ratio (Si/H) in the second process gas is larger than a silicon/hydrogen atom ratio (Si/H) in the first process gas.

6. A vapor phase growth apparatus (100), comprising:

a reactor (10);
a carrier gas supply pipe (15) supplying a carrier gas to the reactor (10);
a first source gas supply pipe (16) supplying a first source gas containing silicon (Si) to the reactor (10);
a second source gas supply pipe (17) supplying a second source gas containing carbon (C) to the reactor (10) ;
a first mass flow controller (25) provided in the carrier gas supply pipe (15) to control a flow rate of the carrier gas supplied to the reactor (10);
a second mass flow controller (26) provided in the first source gas supply pipe (16) to control a flow rate of the first source gas supplied to the reactor (10);
a third mass flow controller (27) provided in the second source gas supply pipe (17) to control a flow rate of the second source gas supplied to the reactor (10);
a pressure adjusting valve (31) adjusting a pressure in the reactor (10); and
a control circuit (34) controlling the first mass flow controller (25), the second mass flow controller (26), the third mass flow controller (27), and the pressure adjusting valve (31) so that an average residence time of the carrier gas in the reactor (10) is shorter than a transition time when switching the flow rate of at least one of the first source gas and the second source gas supplied to the reactor (10) at the transition time.

7. The vapor phase growth apparatus (100) according to claim 6,
wherein the control circuit (34) includes an average residence time calculation circuit (34b) for calculating the average residence time based on a pressure of the reactor (10), a volume of the reactor (10), and the flow rate of the carrier gas.

8. The vapor phase growth apparatus (100) according to claim 7,
wherein the average residence time calculation circuit (34b) calculates the average residence time by dividing a value obtained by multiplying the pressure of the reactor by the volume of the reactor by the flow rate of the carrier gas.

# FIG.1

H₂    SiH₄    C₃H₈    N₂    HCl

PROCESS CONDITION
STORAGE UNIT                34a

AVERAGE RESIDENCE TIME
CALCULATION UNIT            34b

TRANSITION TIME
DETERMINATION UNIT          34c

FLOW RATE INSTRUCTION UNIT   34d

VALVE OPENING
INSTRUCTION UNIT            34e

FIG.2

# FIG.3

ELAPSED TIME AFTER START OF EPITAXIAL GROWTH

FIG.4A

ELAPSED TIME AFTER START OF EPITAXIAL GROWTH

FIG.4B

ELAPSED TIME AFTER START OF EPITAXIAL GROWTH

# FIG.5

TED

BPD

60

59

52

50

# FIG.6

TED

SF

60

59

BPD

56

50

# FIG.7

TED

BPD

60

58

56

54

52

50

FIG.8

H₂  SiH₄  HCl  C₃H₈  N₂

110

34

PROCESS CONDITION
STORAGE UNIT — 34a

AVERAGE RESIDENCE TIME
CALCULATION UNIT — 34b

TRANSITION TIME
DETERMINATION UNIT — 34c

FLOW RATE INSTRUCTION UNIT — 34d

VALVE OPENING
INSTRUCTION UNIT — 34e

# FIG.9

PROCESS CONDITION STORAGE UNIT — 34a

AVERAGE RESIDENCE TIME CALCULATION UNIT — 34b

TRANSITION TIME DETERMINATION UNIT — 34c

FLOW RATE INSTRUCTION UNIT — 34d

VALVE OPENING INSTRUCTION UNIT — 34e

**EP 4 177 931 A2**

**Patent documents cited in the description**

- JP 2021182164 A